# EUROPEAN PATENT SPECIFICATION

(11) **EP 1 935 034 B1**
(45) Date of publication and mention of the grant of the patent: **14.12.2011**
(21) Application number: 06799532.4
(22) Date of filing: 04.10.2006
(51) Int. Cl.: H01L 31/072, H01L 31/18

(54) **METHOD OF MANUFACTURING N-TYPE MULTICRYSTALLINE SILICON SOLAR CELLS**
VERFAHREN ZUM HERSTELLEN VON MULTIKRISTALLINEN SILIZIUM-SOLARZELLEN DES N-TYPS
PROCEDE DE FABRICATION DE CELLULES SOLAIRES AU SILICIUM POLYCRISTALLIN DE TYPE N

(30) Priority: 14.10.2005 NL 1030200
(43) Date of publication of application: 25.06.2008
(73) Proprietor: Stichting Energieonderzoek Centrum Nederland, 1755 LE Petten (NL)
(72) Inventor: KOMATSU, Yuji, NL-1816 EE Alkmaar (NL); GOLDBACH, Hanno, Dietrich, NL-6715 LS Ede (NL); SCHROPP, Rudolf, Emmanuel, Isidore, NL-3972 GE Driebergen (NL); GEERLIGS, Lambert, Johan, NL-1822 KH Alkmaar (NL)
(74) Representative: Ketelaars, Maarten F.J.M.
(86) International application number: PCT/NL2006/050242
(87) International publication number: WO 2007/043881

(56) References cited:
- EP-A- 1 560 272
- US-A- 5 705 828
- CARNEL L ET AL: "PERSPECTIVES FOR A-SI/C-SI HETEROJUNCTION SOLAR CELLS WITH P OR N TYPE BASE" PHOTOVOLTAIC SPECIALISTS CONFERENCE, 2005. CONFERENCE RECORD OF THE THIRTY-FIRST IEEE LAKE BUENA VISTA, FL, USA 3-7 JAN. 2005, PISCATAWAY, NJ, USA,IEEE, US, 3 January 2005 (2005-01-03), pages 1157-1160, XP010824097 ISBN: 0-7803-8707-4
- MARTINUZZI S ET AL: "N-TYPE MULTICRYSTALLINE SILICON WAFERS FOR SOLAR CELLS" PHOTOVOLTAIC SPECIALISTS CONFERENCE, 2005. CONFERENCE RECORD OF THE THIRTY-FIRST IEEE LAKE BUENA VISTA, FL, USA 3-7 JAN. 2005, PISCATAWAY, NJ, USA,IEEE, US, 3 January 2005 (2005-01-03), pages 919-922, XP010822914 ISBN: 0-7803-8707-4
- AZZIZI A ET AL: "ANALYSIS OF CELL-PROCESS INDUCED CHANGES IN MULTICRYSTALLINE SILICON" WORLD CONFERENCE AND EXHIBITION ON PHOTOVOLTAIC SOLAR ENERGY CONVERSION, XX, XX, 11 May 2003 (2003-05-11), pages 1384-1387, XP002379693
- TAGUCHI M ET AL: "An approach for the higher efficiency in the HIT cells" PHOTOVOLTAIC SPECIALISTS CONFERENCE, 2005. CONFERENCE RECORD OF THE THIRTY-FIRST IEEE LAKE BUENA VISTA, FL, USA 3-7 JAN. 2005, PISCATAWAY, NJ, USA,IEEE, US, 3 January 2005 (2005-01-03), pages 866-871, XP010822903 ISBN: 0-7803-8707-4 cited in the application
- CENTURIONI E ET AL: "SILICON HETEROJUNCTION SOLAR CELL: A NEW BUFFER LAYER CONCEPT WITH LOW-TEMPERATURE EPITAXIAL SILICON" IEEE TRANSACTIONS ON ELECTRON DEVICES, IEEE SERVICE CENTER, PISACATAWAY, NJ, US, vol. 51, no. 11, November 2004 (2004-11), pages 1818-1824, XP001214290 ISSN: 0018-9383
- CUEVAS ANDRES ET AL: "Millisecond minority carrier lifetimes in n-type multicrystalline silicon" APPLIED PHYSICS LETTERS, AIP, AMERICAN INSTITUTE OF PHYSICS, MELVILLE, NY, US, vol. 81, no. 26, 23 December 2002 (2002-12-23), pages 4952-4954, XP012032866 ISSN: 0003-6951
- T. BUCK ET AL.: "14,4% screen printed n-type mc-Si solar cells with Al back junction on thin large area wafers" PRESENTED AT 15TH INT. PHOTOVOLTAIC SCIENCE AND ENGINEERING CONF. AND SOLAR ENERGY EXHIB., SHANGHAI, CHINA, [Online] 10 October 2005 (2005-10-10), - 15 October 2005 (2005-10-15) XP002380691 Retrieved from the Internet: URL:http://www.ecn.nl/docs/library/report/ 2005/rx05115.pdf> [retrieved on 2006-05-08]

## Description

The invention relates to the manufacture of solar cells. It more particularly relates to a method of manufacturing solar cells using an n-type multicrystalline silicon substrate.

Multicrystalline silicon (mc-Si) solar cells are usually made of p-type substrate because of its longer diffusion length of the minority carrier than n-type's.
The silicon feedstock for the solar cell industry largely depends on the feedstock for the Integrated Circuit (IC) industry. This is because at the manufacture of silicon, the high quality Si is reserved for the IC industry, and the lesser quality Si forms the feedstock for the solar cell industry. Due to a recent shortage of the whole silicon feedstock, it is desirable to utilize the n-type feedstock more effectively. In addition, solar cells made of n-type substrates may even have superior properties as compared to those made of p-type substrates, because of the relatively longer lifetime of the minority carrier in n-type Si. However, the most effective structure and manufacturing process for n-type multicrystalline silicon solar cells are still subject to research, especially concerning the junction formation. For single crystalline silicon solar cell made of n-type substrate, the so-called HIT (Hetero-junction with Intrinsic Thin-layer) structure was proposed and it proved to have good properties. In the HIT structure, highly doped p-type thin film is deposited on the front side (light incident side) and highly doped n-type thin film is deposited on the back side of a single crystalline silicon substrate. The thin films for both sides are deposited at a relatively low temperature less than 250°C. When applying the same technique on multicrystalline silicon substrates, it was found that the solar cell properties were unsatisfying, see "M. Taguchi, et al.", Proceedings of 31st IEEE Photovoltaic Specialists Conference (Lake Buena Vista, Florida, 2005) p. 866-871.

Nowadays, to improve the bulk property of multicrystalline silicon substrates, a gettering process by way of phosphorus diffusion is used. This process gets rid of impurities like iron included at the process of casting the multicrystalline ingot. Hydrogen passivation by annealing after depositing the film which includes hydrogen also has an effect to improve the bulk property of multicrystalline silicon substrates. Both these processes have already been used at the manufacture of solar cells made of p-type multicrystalline substrates. However, there has been no proper solution for integrating these two processes into the manufacturing of a HIT structure in an n-type multicrystalline silicon substrate. This is because the thin film layer deposited on the substrate, cannot maintain its quality with high temperature process like phosphorus diffusion or hydrogen passivation.

Camel et al. in "Perspectives for a-Si/C-Si heterojunction solar cells with p or N type base", Photovoltaic Specialists Conference, 2005, Thirty-First IEEE Lake Buena Vista, FL USA 3-7 Jan 2005, pages 1157-1160, Piscataway NJ USA, IEEE, US 3 January 2005" discloses a-Si/C-Si heterojunction solar cells with p or n type base. A solar cell with heterojunction emitter on n-type Cz Si with thermally in-diffused BSF at the back surface is described.

Martinuzzi et al. in "N-type multicrystalline silicon wafers for solar cells, Photovoltaic Specialists Conference, 2005, Thirty-First IEEE Lake Buena Vista, FL USA 3-7 Jan 2005, pages 919-922, Piscataway NJ USA, IEEE, US 3 January 2005" discloses n-type multicrystalline silicon wafers for solar cells. A multicrystalline Si substrate material composed of tops and tails of Cz ingots is used as substrate for a conventional front junction solar cell and a rear junction solar cell.

Azzizi et al. in "Analysis of cell-process induced chances in multicrystalline silicon, World Conference and Exhibition on Photovoltaic Solar Energy Conversion, 11 may 2003 pages 1384-1387", discloses an analysis of cell-process induced changes in multicrystalline silicon. The effect of individual process steps on the Quality of multicrystalline silicon is analyzed for different ingot positions of the multicrystalline Si ingot material.

US-A-5 705 828 discloses a photovoltaic device having a multilayer semiconductor structure which includes a n-i-n or p-i-p portion.

Cuevas et al. in "Millisecond minority carrier lifetimes in n-type multicrystalline silicon", Applied Physics Letters, American Institute of Physics, vol. 81, no. 26, December 2002, pages 4952-4954" discloses a method for obtaining high minority carrier lifetimes in n-type multicrystalline silicon grown by directional solidification and subjected to phosphorous gettering.

It is an object of the present invention to manufacture a solar cell having a HIT structure using an n-type multicrystalline silicon substrate wherein the deposited thin film quality is not effected by other processing steps.

This object is achieved by a method of manufacturing a solar cell from a n-type multicrystalline silicon substrate comprising in sequence:
- providing the n-type multicrystalline silicon substrate having a front side and a back side, the front side being the light incident side;
- diffusing phosphorus into both sides of said substrate to render a phosphorus diffusion layer on said front side and a phosphorus diffusion layer on said back side;
- depositing a dielectric film comprising hydrogen onto said phosphorus diffusion layer at said back side;
- removing said phosphorus diffusion layer at said front side;
- texturing said front side of said substrate, after the removal of said phosphorous diffusion layer, and then
- depositing a p-type silicon thin film on said front side for forming a heterojunction, wherein after the step of depositing said dielectric film, and prior to the formation of the heterojunction, the method comprises annealing to emit the hydrogen in the dielectric film and penetrate the hydrogen into the substrate, wherein the annealing step is carried out at a temperature which is more than 50°C higher than a temperature at the dielectric film deposition step.

According to the invention, the thin film heterojunction is formed after the diffusion step. Therefore, heating the p-type silicon thin film at higher temperatures than its deposition temperature can be avoided, and so the quality of the p-type silicon thin film is maintained.

The dielectric film is deposited on the phosphorus-diffused layer. With the dielectric film, the inside reflection at the back side is improved and the current of the solar cell is increased. Due to the annealing, a hydrogen passivation is carried out. This passivation step is carried out prior to the formation of the thin film heterojunction. Therefore, heating the p-type silicon thin film at higher temperatures than its deposition temperature can be avoided, and so the quality of the p-type silicon thin film is maintained.

Preferably, the dielectric comprises SiN. If silicon nitride (SiN) is adopted for the dielectric film, the SiN can protect the phosphorus-diffused layer from a NaOH solution and a dilute fluoric acid which may be used for the pre-treatment of the formation of the thin film heterojunction.

The phosphorus diffusion layer at the back side of the substrate may be provided by first diffusing phosphorus into both sides of the substrate to render a diffusion layer on the front side and on the back side, and then removing the diffusion layer at the front side.

The invention also relates to a solar cell manufactured by the above mentioned method.

Further advantages and characteristics of the present invention will become clear on the basis of a description of a number of embodiments, in which reference is made to the appended drawings, in which:
Figures 1A-1H show an example of the practical formation of a first embodiment of this invention;
Figure 2 shows a flow chart of a manufacturing process corresponding to the formation of figures 1A-1H;
Figure 3 shows a flow chart of a solar cell manufacturing process according to the state of the art;
Figure 4 shows the resulting solar cell of the manufacturing process of figure 3;
Figure 5 shows a flow chart of a solar cell manufacturing process according to a second embodiment of the invention;
Figure 6 shows the resulting solar cell of the manufacturing process of figure 5;
Figure 7 shows a flow chart of a manufacturing process according to a third embodiment of the invention;
Figure 8 shows a flow chart of a manufacturing process according to a fourth embodiment of the invention.

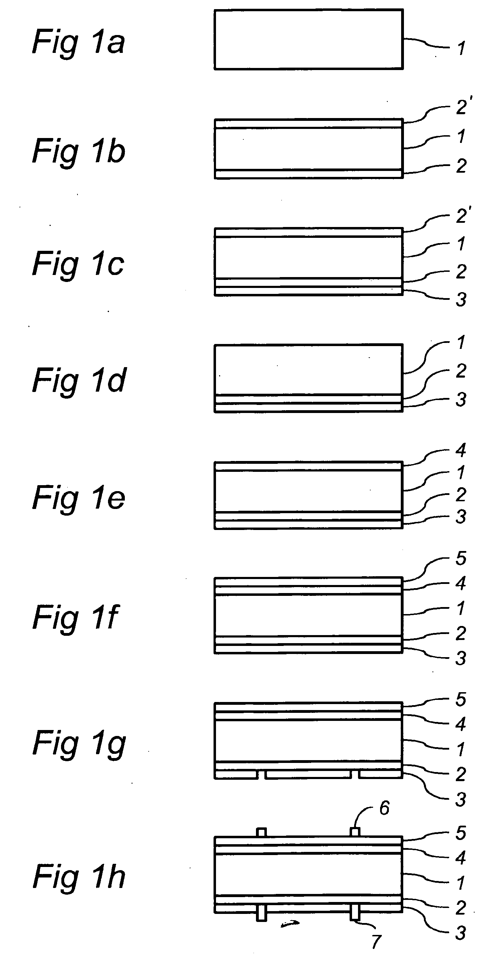

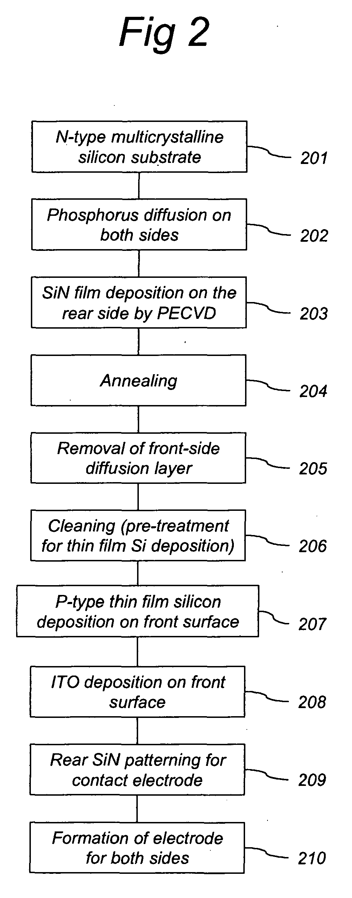

Figures 1A-1H show an example of a practical formation of a solar cell according to an embodiment of the invention, and figure 2 shows a corresponding flow chart of the manufacturing process. In a first step, a multicrystalline silicon substrate of n-type is provided, see figure 1A and step 201 of figure 2. Then in a step 202, on both sides of the substrate 1, phosphorus diffusion layers 2, 2' are formed in for example a mixed atmosphere of N₂/O₂/POCl₃ at temperature between for example 800 - 880°C. The result is shown in figure 1B. This diffusion may also be carried out at N₂ atmosphere after coating of phosphorus glass paste. Then, in a step 203, a silicon nitride film 3 is deposited on the back side of the substrate 1 using plasma enhanced chemical vapor deposition (PECVD) at 300-500°C with mixed gases of SiH₄/NH₃/N₂. Any type of plasma may be applicable, such like direct plasma with parallel plate, microwave remote plasma with quartz tube, expanding thermal plasma using arc discharge, etc. Hotwire CVD may also be applicable. Using these kinds of method, hydrogen is included in the silicon nitride film 3 with the content of several percentages. The result of step 203 is shown in figure 1C. After the deposition of the silicon nitride film in step 203, the substrate 1 is annealed at a temperature of more than 50 °C higher than the deposition temperature, see step 204. The annealing may for example be performed at temperatures between 700-800°C for about several seconds. Preferably, the annealing temperature does not exceed 1000°C. Next, in a step 205, the phosphorus-diffused layer 2' on the front side is removed using for example a 10% NaOH solution at a temperature of about 90°C. The result is shown in figure 1D. The silicon nitride film 3 at the back side is rarely etched by the NaOH so lution, consequently the phosphorus-diffused layer on the back side is protected from the NaOH solution. After the removal of the phosphorus-layer 2', the surface may be textured by a chemical solution like 3% NaOH or by another method like reactive ion etching.

Then in step 206, the front surface of the substrate is cleaned using a so-called "RCA-cleaning" for semiconductor, which includes the chemical process of NH₄OH/ H₂O₂/H₂O at about 60 °C, HF dip, HCl/H₂O₂/H₂O at about 70°C, and then HF dip again. This cleaning method can be more simplified, or other methods like plasma cleaning could be used.

Next in step 207, a thin film silicon layer of p-type 4, see also figure 1E, is deposited on the front surface using PECVD at a temperature between 150-250°C with mixed gases of H₂/SiH₄/B₂H₆. The thin film silicon layer 4 may comprise microcrystalline silicon (µc-Si) or amorphous silicon (a-Si). Also, the thin film silicon layer 4 may comprise either a single p-type layer or multiple layers of p-type silicon and intrinsic layers. The deposition temperature may be even higher than 250°C as long as it is lower than that of the annealing process, see step 204. The deposition method may be other like hotwire CVD.

In a step 208, an indium tin oxide (ITO) layer 5, see figure 1F, is deposited on the front surface with sputtering at temperatures between 150-250°C with mixed gases of Ar/O₂ and an ITO target. Other deposition methods may be used such as vacuum evaporation methods. Alternatively, another type of transparent conductive film can be used, such as zinc oxide. Next, contact holes are formed in the silicon nitride layer 3 on the back side, using for example a photolithographic process, see figure 1G and step 209 of figure 2. Alternatively, screen printing using printable etching paste (product of Merck KGaA, Germany) can be used to make contact holes in the silicon nitride layer 3. Finally, in a step 210, front contacts 6 and back contacts 7 are formed with screen printing with silver paste. The result is shown in figure1H. The firing temperature of the paste is preferably lower than that of step 207.

The process mentioned above simply represents only one example, and some parts can be substituted or enhanced by other known processing techniques. Instead of diffusing phosphorus into both sides of the substrate and then removing the diffusion layer at the front side, it is also possible to diffuse only on the back side by protecting the front side of the substrate 1 with some kind of coating and to eliminate the process of removal.
Below, a further explanation of the invention is made using some other practical examples.

In a laboratory, 240 wafers with a thickness between 200-240µm comprising a n-type mc-Si substrate with a resistivity of 0.5-3 ohm·cm were prepared. These wafers were sliced out from one square column with the size (width and depth) of 125 x125 mm², which was cut out from one casted ingot. The wafers were numbered #1 to #240 according to the position in the original ingot. They were divided into six groups wherein every sixth wafer was placed in a specific group. Each group had 40 wafers. Hereafter, the groups are referred to as group B; group C, group D, group E, group F, group G wherein:
Group B: #1, #7, #13, ...., #235
Group C: #2, #8, #14, ..., #236
Group D: #3, #9, #15, ..., #237
Group E: #4, #10, #16, ..., #238
Group F: #5, #11, #17, ..., #239
Group G: #6, #12, #18, ..., #240.

### [Group B]

Group B is a typical example of the invention. The solar cells structure shown in figure 1H is fabricated through the processes shown in figure 2. The specific process condition at each process step is as follows:
step 202: Phosphorus diffusion at the temperature of 830∼850°C with phosphorus glass coating.
step 203: Microwave remote plasma with quartz tube at the temperature of 350~400°C. step 204: Annealing at the temperature of 650~750°C for 5~20 seconds.
step 205: Non textured surface after the removal of the front phosphorus-doped layer. step 206: Surface cleaning with "RCA-cleaning".
step 207: p-type/intrinsic a-Si deposition with the parallel plate plasma-enhanced CVD of 13.56 MHz at the temperature of 200°C with mixed gases of SiH₄/H₂/B₂H₆.
step 208: Magnetron sputtering of ITO at the temperature of 200°C.
step 209: Contact patterning with screen printing using printable etching paste.
step 210: Screen printing of silver paste and firing at 200°C.

### [Group C]

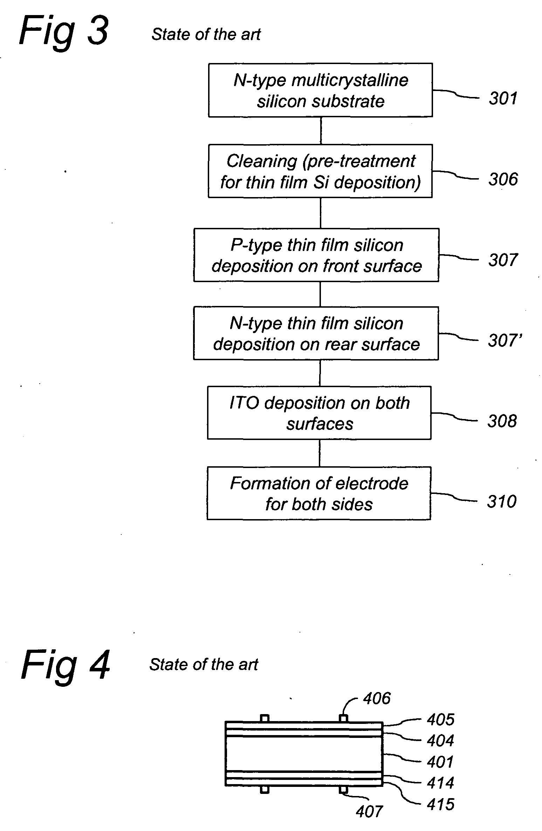

Group C was a reference group with a conventional HIT structure made by a conventional process. A flow chart of this fabricating process is shown in figure 3. First in a step 301, a n-type multicrystalline silicon substrate is provided. Then a cleaning step 306 follows which is the same as step 206 of figure 2. Next, a step 307 follows in which a p-type silicon thin film is deposited as was done in step 207 of figure 2. Next, in a step 307', a n-type/intrinsic a-Si deposition by way of a parallel plate plasma-enhanced CVD using 13.56 MHz at a temperature of 200°C with mixed gases of SiH₄/H₂/PH₃ is performed. Next in a step 308, an ITO layer is deposited on both sides of the substrate. Finally, electrodes or formed on both sides, see step 310.

Figure 4 shows the result of the processing steps of figure 3. The solar cell comprises a n-type multicrystalline silicon substrate 401. At the front side of the substrate, a thin film silicon layer of p-type 404 is fabricated. On top of the thin film silicon layer 404, an indium tin oxide (ITO) layer 405 is fabricated. On top of the ITO layer 405, front contact 406 are formed. At the back side of the substrate, a n-type/intrinsic a-Si thin film deposition layer 414 is fabricated. On the n-type silicon thin film deposition layer 414 an ITO layer is deposited, see layer 415.

### [Group D]

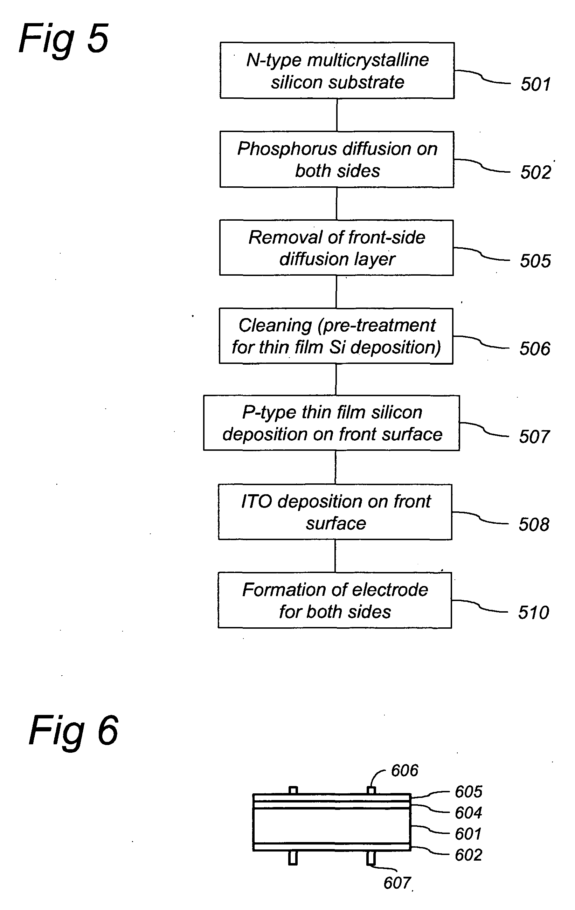

Group D is a group of solar cells fabricated according to an embodiment, where the solar cells do not have a back side silicon nitride film. The fabricating process is shown in figure 5. This process is simpler than that of the manufacturing process of group B because the relatively expensive SiN process is eliminated. This embodiment starts with a step 501 in which an n-type multicrystalline silicone substrate is provided. In a step 502 phosphorus diffusion layers are formed on both sides of the substrate. Next, in a step 505, the front side diffusion layer is removed. This is achieved by way of an etching method comprising the coating of the back side with a negative photo resist, such as OMR 85 (available from Tokyo Oka Kogyo Inc.), followed by the etching of the front side with a solution comprising HNO₃/HF=10:1 for a period of about 1 minute. Finally, the OMR85 is removed using OMR-remover (Tokyo Oka Kogyo Inc.). Next, a cleaning step 506 is performed identical to step 206. This step is followed by step 507 in which a p-type silicon thin film is deposited as was done in step 207, see figure 2. Next, a step 508 is performed which is identical to step 208. Finally, electrodes are formed on both sides, see step 510.

It is noted that instead of forming a phosphorus diffusion layers on both sides of the substrate, it is possible to form the phosphor diffusion layer at only the back side, using e.g. a front-to-front configuration during the diffusion step. The front side diffusion layer will then not be formed and does not need to be removed. A cleaning step in this case is not necessary.

The resulting solar cell structure is shown in figure 6. The solar cell comprises a n-type multicrystalline substrate 601. At the back side a phosphorus diffusion layers 602 is formed. At the front side, a thin film silicon layer of p-type 604 is deposited forming the heterojunction. An indium tin oxide (ITO) layer 605 is deposited on the thin film silicon layer 604 at the front side. The solar cell further comprises front contacts 606 and back contacts 607.

### [Group E]

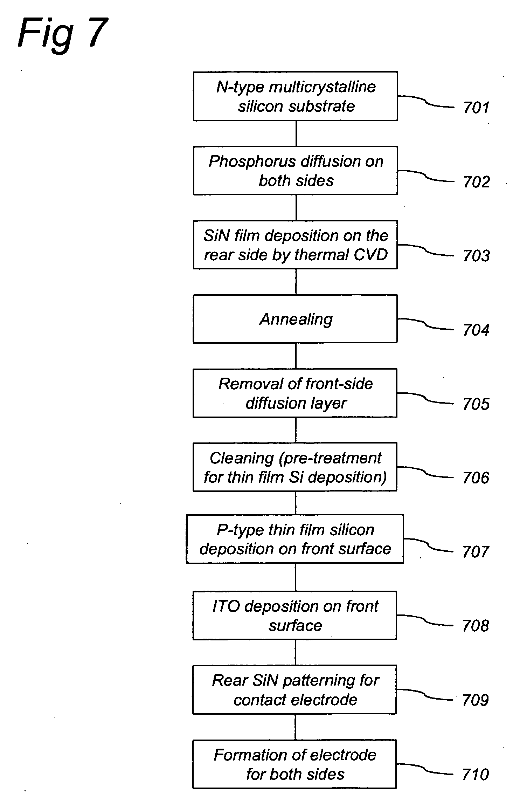

For group E, the hydrogen content in the SiN film 3 is less than 0.3 at%, while that of group B is between 5-10 at%. The hydrogen content in the SiN film 3 was determined by measuring the absorption of infrared light by Si-H and N-H bonds in the SiN film 3 using a Fourier Transform Infrared Spectrometer. A flow chart of the fabricating process is shown in figure 7. The specific processing steps of this embodiment are the same as those of group B, see figure 2, except for a step 703 and 704. In step 703, SiN is deposited with thermal CVD at a temperature of 800°C using mixed gases of SiH4/ NH3. In step 704, an annealing step is performed at a temperature between 850-900°C for a period between 5-20 seconds.

### [Group F]

For group F, the hydrogen content in SiN film was between 20-25 at%, while that of group B was between 5-10 at%. The fabricating process is the same as that used for group B except for the deposition temperature at the deposition of the SiN film, see also step 203 in figure 2. The deposition temperature at group F is between 130-170°C.

### [Group G]

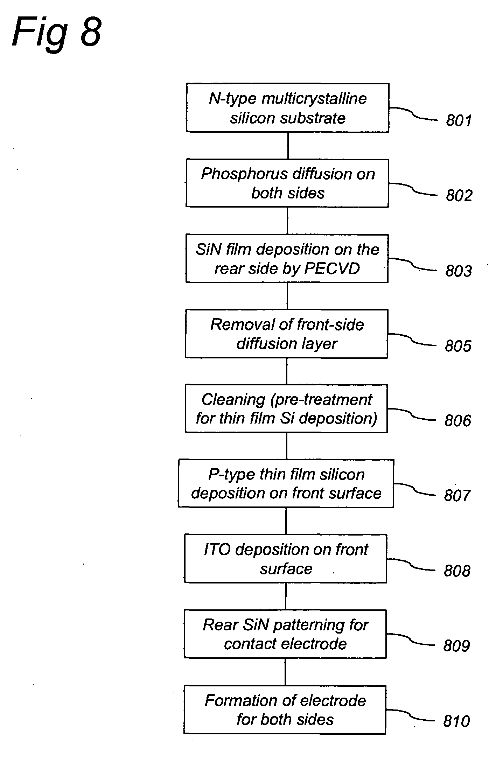

For group G, the annealing step after the SiN deposition is eliminated. A flow chart of the fabrication process is shown in figure 8. As compared to the flow chart of figure 2, step 204 is eliminated. Steps 802 to 810 are identical to steps 202 to 210, respectively.

### [Results]

The current-voltage characteristics of the completed cells were measured with a procedure described in IEC 60904. Table I shows the average values of the cell properties of each group, wherein Jsc is the short circuit current, Voc is the open circuit voltage and FF is the Fill Factor.

| Group | Remark | Hydrogen in SiN [at%] | Anneal SiN [°C] | Jsc [mA/cm²] | Voc [mV] | FF [%] | Efficiency [%] |
|---|---|---|---|---|---|---|---|
| B | Typical example | 7 | 650 - 750 | 32.6 | 613 | 77.2 | 15.4 |
| C | Conventional HIT | - | - | 29.6 | 595 | 77.4 | 13.6 |
| D | Without back SiN | - | - | 30.5 | 605 | 77.1 | 14.2 |
| E | Low H content SiN | <0.3 | 850 - 900 | 31.8 | 608 | 77.1 | 14.9 |
| F | High H content SiN | 22 | 650 - 750 | 31.7 | 608 | 77.2 | 14.9 |
| G | Without anneal SiN | 9 | - | 31.4 | 607 | 77.2 | 14.7 |

When comparing group D with group C, it shows that the short circuit current Jsc and the open circuit voltage Voc are improved. This is most certainly due to the presence of the back side phosphorus-doped layer 2. Because of the phosphorus diffusion process, see step 202 of figure 2, iron contamination present in the casted wafers is gettered by diffused phosphorus atoms and as a consequence the substrate quality is improved.

When comparing group G with D, it can be seen that especially Jsc is improved. This is mainly due to the back side SiN film 3, see figure 1H. This layer enhances the inner reflection of the incident light. The same effect can be expected with other dielectric films that have similar optical properties like for example titanium oxide.

When comparing group B with E, F, and G, it is clear that both an appropriate hydrogen content and an annealing step following the SiN deposition will cause a further improvement of Jsc and Voc. This is because the hydrogen in the SiN film 3 passivates the defect in the substrates when annealed under appropriate conditions.

This invention provides a method of manufacturing a HIT structure for multicrystalline silicon substrate made of n-type multicrystalline silicon substrates. Through the process of the phosphorus diffusion, impurities like iron included during the ingot-casting are gettered and the bulk property is improved. The phosphorus-diffused layer also serves as a back surface field to raise the voltage and a back contact with low resistivity. Preferably, the hydrogen content of the dielectric film described above is between 0.5 -15%. When the dielectric film is annealed at a temperature which is more than 50°C higher than the deposition temperature, the hydrogen in the dielectric film is emitted and penetrates in the substrate. In this way the multicrystalline silicon inside the bulk is passivated and the solar cell properties are improved.

As described above, the high temperature processes of the phosphorus diffusion, dielectric film deposition, and hydrogen passivation are carried out prior to the formation of thin film heterojunction. Therefore, heating the thin film at higher than its deposition temperature after the deposition can be avoided, and the quality of the thin film is maintained. Moreover, if silicon nitride (SiN) is adopted for the dielectric film, SiN can protect the phosphorus-diffused layer from NaOH solution and dilute fluoric acid which is required for the pre-treatment of the formation of the thin film heterojunction. Consequently, this invention makes it possible to combine the high temperature processes with the formation of a heterojunction.

With adopting the invention, the improvement of 0.6-1.8 points in the conversion efficiency can be expected compared to the conventional HIT structure of n-type multicrystalline-Si substrate.

## Claims

1. Method of manufacturing a solar cell from a n-type multicrystalline silicon substrate, comprising
in sequence:
- providing the n-type multicrystalline silicon substrate having a front side and a back side, the front side being the light incident side;
- diffusing phosphorus into both sides of said substrate to render a phosphorus diffusion layer on said front side and a phosphorus diffusion layer on said back side;
- depositing a dielectric film comprising hydrogen onto said phosphorus diffusion layer at said back side;
- removing said phosphorus diffusion layer at said front side;
- texturing said front side of said substrate, after the removal of said phosphorous diffusion layer, and then
- depositing a p-type silicon thin film on said front side for forming a heterojunction, wherein after the step of depositing said dielectric film, and prior to the formation of the heterojunction, the method comprises annealing to emit the hydrogen in the dielectric film and penetrate the hydrogen into the substrate, wherein the annealing step is carried out at a temperature which is more than 50°C higher than a temperature at the dielectric film deposition step.

2. Method according to claim 1, wherein said annealing is done between 700 and 800 °C.

3. Method according to claim 1, wherein the annealing temperature does not exceed 1000 °C.

4. Method according to claim 3, wherein said front side of said substrate is textured by a chemical solution.

5. Method according to claim 4, wherein said chemical solution is a 3% NaOH solution.

6. Method according to claim 3, wherein texturing said front side of said substrate is performed by way of reactive ion etching.

7. Method according claim 1, wherein the phosphorus diffusion layer at said front side is removed after said annealing.

8. Method according to claim 1, wherein said dielectric film comprises SiN.

9. Method according to any of the preceding claims, wherein said p-type silicon thin-film is deposited at a temperature under 250°C.

10. Method according to any of the claims 8 - 9, wherein a hydrogen content of the dielectric film is between 0.5 - 15 atomic %.

11. Method according to any of the claims 8 - 10, said method further comprising:
- ITO deposition on said front side;
- patterning said dielectric film for electrode contact;
- forming electrodes on both sides.

## Patentansprüche

1. Verfahren zum Herstellen einer Solarzelle aus einem multikristallinen n-Typ-Siliziumsubstrat, umfassend
aufeinanderfolgend:
- Bereitstellen des multikristallinen n-Typ-Siliziumsubstrats mit einer Vorderseite und einer Rückseite, wobei die Vorderseite die Lichteinfallseite ist;
- Diffundieren von Phosphor in beide Seiten des Substrats, um eine Phosphordiffusionsschicht auf der Vorderseite und eine Phosphordiffusionsschicht auf der Rückseite zu erzeugen;
- Aufbringen eines dielektrischen Films, der Wasserstoff umfasst, auf der Phosphordiffusionsschicht auf der Rückseite;
- Entfernen der Phosphordiffusionsschicht an der Vorderseite;
- Strukturieren der Vorderseite des Substrats nachdem die Phosphordiffusionsschicht entfernt wurde, und anschließend
- Aufbringen eine p-Typ-Siliziumdünnfilms auf der Vorderseite, um einen Heteroübergang zu bilden, wobei nach dem Schritt des Aufbringens des dielektrischen Films und vor der Bildung des Heteroübergangs, das Verfahren Ausheizen umfasst, um den Wasserstoff in den dielektrischen Film abzugeben und den Wasserstoff in das Substrat eindringen zu lassen, wobei der Schritt des Ausheizens bei einer Temperatur durchgeführt wird, die mehr als 50 °C höher ist als die Temperatur beim Schritt des Aufbringens des dielektrischen Films.

2. Verfahren nach Anspruch 1, wobei das Ausheizen zwischen 700 und 800 °C durchgeführt wird.

3. Verfahren nach Anspruch 2, wobei die Ausheiztemperatur 1000 °C nicht übersteigt.

4. Verfahren nach Anspruch 3, wobei die Vorderseite des Substrats mit einer chemischen Lösung strukturiert wird.

5. Verfahren nach Anspruch 4, wobei die chemische Lösung eine 3%ige NaOH-Lösung ist.

6. Verfahren nach Anspruch 3, wobei Strukturieren der Vorderseite des Substrats mittels reaktiver Ionenätzung durchgeführt wird.

7. Verfahren nach Anspruch 1, wobei die Phosphordiffusionsschicht an der Vorderseite nach dem Ausheizen entfernt wird.

8. Verfahren nach Anspruch 1, wobei der dielektrische Film SiN umfasst.

9. Verfahren nach einem der vorherigen Ansprüche, wobei der p-Typ-Siliziumdünnfilm bei einer Temperatur unterhalb 250 °C aufgebracht wird.

10. Verfahren nach einem der Ansprüche 8 - 9, wobei der Wasserstoffgehalt des dielektrischen Films zwischen 0,5 - 15 Atom% ist.

11. Verfahren nach einem der Ansprüche 8 - 10, wobei das Verfahren weiterhin umfasst:
- ITO-Beschichtung auf der Vorderseite;
- Strukturieren des dielektrischen Films für einen Elektrodenkontakt;
- Bilden von Elektroden auf beiden Seiten.

## Revendications

1. Procédé de fabrication d'une cellule solaire à partir d'un substrat de silicium polycristallin de type n, comprenant
en séquence :
- la fourniture du substrat de silicium polycristallin de type n ayant un côté avant et un côté arrière, le côté avant étant le côté de lumière incidente ;
- la diffusion de phosphore dans les deux côtés dudit substrat pour constituer une couche de diffusion de phosphore sur ledit côté avant et une couche de diffusion de phosphore sur ledit côté arrière ;
- le dépôt d'un film diélectrique comprenant de l'hydrogène sur ladite couche de diffusion de phosphore audit côté arrière ;
- le retrait de ladite couche de diffusion de phosphore audit côté avant ;
- la texturation dudit côté avant dudit substrat, après le retrait de ladite couche de diffusion de phosphore, et ensuite
- le dépôt d'une couche mince de silicium de type p sur ledit côté avant pour former une hétérojonction, où après l'étape de dépôt dudit film diélectrique, et avant la formation de l'hétérojonction, le procédé comprend un recuit pour émettre l'hydrogène dans le film diélectrique et faire pénétrer l'hydrogène dans le substrat, où l'étape de recuit est conduite à une température qui est supérieure de 50 °C à la température à l'étape de dépôt de film diélectrique.

2. Procédé selon la revendication 1, dans lequel ledit recuit est effectué entre 700 et 800 °C.

3. Procédé selon la revendication 1, dans lequel la température de recuit ne dépasse pas 1000 °C.

4. Procédé selon la revendication 3, dans lequel ledit côté avant dudit substrat est texturé par une solution chimique.

5. Procédé selon la revendication 4, dans lequel ladite solution chimique est une solution de NaOH à 3 %.

6. Procédé selon la revendication 3, dans lequel la texturation dudit côté avant dudit substrat est effectuée au moyen de l'attaque d'ions réactifs.

7. Procédé selon la revendication 1, dans lequel la couche de diffusion de phosphore audit côté avant est enlevée après ledit recuit.

8. Procédé selon la revendication 1, dans lequel ledit film diélectrique comprend SiN.

9. Procédé selon l'une quelconque des revendications précédentes, dans lequel ladite couche mince de silicium de type p est déposée à une température inférieure à 250 °C.

10. Procédé selon l'une quelconque des revendications 8 à 9, dans lequel la teneur en hydrogène du film diélectrique est comprise entre 0,5 et 15 % atomique.

11. Procédé selon l'une quelconque des revendications 8 à 10, ledit procédé comprenant en outre :
- le dépôt d'ITO sur ledit côté avant ;
- le modelage dudit film diélectrique pour contact d' électrode ;
- la formation d'électrodes sur les deux côtés.
